# EUROPEAN PATENT APPLICATION

(11) **EP 1 162 654 A1**
(43) Date of publication of application: **12.12.2001**
(21) Application number: 00111820.7
(22) Date of filing: 06.06.2000
(51) Int. Cl.: H01L 21/60, H01L 23/485

(54) **Method for mounting a semiconductor chip on a substrate, and semiconductor device adapted for mounting on a substrate**

(71) Applicant: Chen, I-Ming, Nei-Hu District, Taipei City (TW)
(72) Inventor: Chen, I-Ming, Nei-Hu District, Taipei City (TW)
(74) Representative: VOSSIUS & PARTNER

(57) **Abstract**

A semiconductor device is adapted for mounting on a substrate (9) that has a chip-mounting region provided with a plurality of solder points (90). The semiconductor device includes a semiconductor chip having a pad-mounting surface provided with a plurality of bonding pads which are disposed on the pad-mounting surface at locations that are offset from locations of corresponding ones of the solder points (90) on the chip-mounting region. Conductive bodies (3) are formed on the pad-mounting surface to establish the required electrical connection among the bonding pads and the corresponding ones of the solder points (90).

## Description

The invention relates to a method for mounting a semiconductor chip on a substrate and to a semiconductor device that is adapted for mounting on a substrate.

With the rapid advancement in semiconductor fabrication technology, the bonding pads on the surface of a semiconductor chip are getting smaller in size, and the distances between adjacent bonding pads are getting shorter. These can create difficulty when connecting the semiconductor chip to an external circuit, and can affect adversely the production yield.

Therefore, the main object of the present invention is to provide a method for mounting a semiconductor chip on a substrate so as to overcome the aforesaid drawback.

Another object of the present invention is to provide a semiconductor device adapted for mounting on a substrate and capable of overcoming the aforesaid drawback.

According to one aspect of the present invention, there is provided a method for mounting a semiconductor chip on a substrate. The substrate has a chip-mounting region provided with a plurality of solder points. The semiconductor chip has a pad-mounting surface provided with a plurality of bonding pads, which are to be connected to corresponding ones of the solder points and which are disposed on the pad-mounting surface at locations that are offset from locations of the corresponding ones of the solder points on the chip-mounting region. The method comprises the steps of:
providing a conductor-forming mold having one side formed with a plurality of conductor-receiving cavities, each of the conductor-receiving cavities having a first cavity part that is disposed in the conductor-forming mold at a location corresponding to that of a respective one of the bonding pads on the pad-mounting surface, and a second cavity part that extends from the first cavity part and that is disposed in the conductor-forming mold at a location corresponding to that of a respective one of the solder points on the chip-mounting region of the substrate;
filling the conductor-receiving cavities with a conductive metal paste to form conductive bodies respectively therein, each of the conductive bodies having an extension portion that is disposed in the first cavity part of the respective one of the conductor-receiving cavities, and an electrical connection portion that is disposed in the second cavity part of the respective one of the conductor-receiving cavities on one end of the extension portion; and
through a transfer printing unit, transferring the conductive bodies from the conductor-forming mold to the pad-mounting surface of the semiconductor chip such that the extension portion of each of the conductive bodies is connected electrically to the respective one of the bonding pads, and such that the electrical connection portion of each of the conductive bodies extends to the location corresponding to that of the respective one of the solder points on the chip-mounting region of the substrate.

According to another aspect of the present invention, there is provided a method for mounting a semiconductor chip on a substrate. The substrate has a chip-mounting region provided with a plurality of solder points. The semiconductor chip has a pad-mounting surface provided with a plurality of bonding pads, which are to be connected to corresponding ones of the solder points and which are disposed on the pad-mounting surface at locations that are offset from locations of the corresponding ones of the solder points on the chip-mounting region. The method comprises the steps of:
superimposing a conductor-forming plate on the pad-mounting surface of the semiconductor chip, the conductor-forming plate being formed with a plurality of holes at positions registered with the bonding pads on the pad-mounting surface, each of the holes having a first hole part that exposes at least a part of the registered one of the bonding pads on the pad-mounting surface, and a second hole part that exposes a respective portion of the pad-mounting surface and that extends from the first hole part to a location corresponding to that of a respective one of the solder points on the chip-mounting region of the substrate, the holes being confined by walls that cooperate with the pad-mounting surface to form conductor-receiving spaces; and
using a conductive metal paste as printing material, printing on the conductor-forming plate to form conductive bodies in the conductor-receiving spaces, each of the conductive bodies having an extension portion that is disposed in the first hole part to connect electrically with the registered one of the bonding pads, and an electrical connection portion that is disposed in the second hole part on one end of the extension portion and that extends to the location corresponding to that of the respective one of the solder points on the chip-mounting region of the substrate.

According to still another aspect of the present invention, there is provided a method for mounting a semiconductor chip on a substrate. The substrate has a chip-mounting region provided with a plurality of solder points. The semiconductor chip has a pad-mounting surface provided with a plurality of bonding pads, which are to be connected to corresponding ones of the solder points and which are disposed on the pad-mounting surface at locations that are offset from locations of the corresponding ones of the solder points on the chip-mounting region. The method comprises the steps of:
forming a photoresist layer on the pad-mounting surface of the semiconductor chip;
forming a plurality of conductor-receiving cavities in the photoresist layer at positions registered with the bonding pads on the pad-mounting surface, each of the conductor-receiving cavities having a first cavity part that exposes at least a part of the registered one of the bonding pads on the pad-mounting surface, and a second cavity part that exposes a respective portion of the pad-mounting surface and that extends from the first cavity part to a location corresponding to that of a respective one of the solder points on the chip-mounting region of the substrate; and
forming conductive bodies in the conductor-receiving cavities, each of the conductive bodies having an extension portion that is disposed in the first cavity part to connect electrically with the registered one of the bonding pads, and an electrical connection portion that is disposed in the second cavity part on one end of the extension portion and that extends to the location corresponding to that of the respective one of the solder points on the chip-mounting region of the substrate.

According to yet another aspect of the present invention, a semiconductor device is adapted for mounting on a substrate having a chip-mounting region provided with a plurality of solder points. The semiconductor device comprises:
a semiconductor chip having a pad-mounting surface provided with a plurality of bonding pads which are disposed on the pad-mounting surface at locations that are offset from locations of corresponding ones of the solder points on the chip-mounting region; and
a plurality of conductive bodies, each of which has an extension portion that is connected electrically to a respective one of the bonding pads, and an electrical connection portion that is formed on one end of the extension portion and that extends to a location corresponding to that of a respective one of the solder points on the chip-mounting region of the substrate.

In a preferred embodiment, the conductive bodies are formed by:
providing a conductor-forming mold having one side formed with a plurality of conductor-receiving cavities, each of the conductor-receiving cavities having a first cavity part that is disposed in the conductor-forming mold at a location corresponding to that of a respective one of the bonding pads on the pad-mounting surface, and a second cavity part that extends from the first cavity part and that is disposed in the conductor-forming mold at a location corresponding to that of a respective one of the solder points on the chip-mounting region of the substrate;
filling the conductor-receiving cavities with a conductive metal paste to form the conductive bodies respectively therein, the extension portions of the conductive bodies being disposed in the first cavity parts of the conductor-receiving cavities, the electrical connection portions of the conductive bodies being disposed in the second cavity parts of the conductor-receiving cavities; and
through a transfer printing unit, transferring the conductive bodies from the conductor-forming mold to the pad-mounting surface of the semiconductor chip.

In another preferred embodiment, the conductive bodies are formed by:
superimposing a conductor-forming plate on the pad-mounting surface of the semiconductor chip, the conductor-forming plate being formed with a plurality of holes at positions registered with the bonding pads on the pad-mounting surface, each of the holes having a first hole part that exposes at least a part of the registered one of the bonding pads on the pad-mounting surface, and a second hole part that exposes a respective portion of the pad-mounting surface and that extends from the first hole part to a location corresponding to that of a respective one of the solder points on the chip-mounting region of the substrate, the holes being confined by walls that cooperate with the pad-mounting surface to form conductor-receiving spaces; and
using a conductive metal paste as printing material, printing on the conductor-forming plate to form the conductive bodies in the conductor-receiving spaces, the extension portions of the conductive bodies being disposed in the first hole parts of the holes, the electrical connection portions of the conductive bodies being disposed in the second hole parts of the holes.

According to a further aspect of the present invention, a semiconductor device is adapted for mounting on a substrate having a chip-mounting region provided with a plurality of solder points. The semiconductor device comprises:
a semiconductor chip having a pad-mounting surface provided with a plurality of bonding pads which are disposed on the pad-mounting surface at locations that are offset from locations of corresponding ones of the solder points on the chip-mounting region;
a photoresist layer formed on the pad-mounting surface of the semiconductor chip, the photoresist layer being formed with a plurality of conductor-receiving cavities at positions registered with the bonding pads on the pad-mounting surface, each of the conductor-receiving cavities having a first cavity part that exposes at least a part of the registered one of the bonding pads on the pad-mounting surface, and a second cavity part that exposes a respective portion of the pad-mounting surface and that extends from the first cavity part to a location corresponding to that of a respective one of the solder points on the chip-mounting region of the substrate, and
a plurality of conductive bodies formed respectively in the conductor-receiving cavities, each of the conductive bodies having an extension portion that is disposed in the first cavity part to connect electrically with the registered one of the bonding pads, and an electrical connection portion that is disposed in the second cavity part on one end of the extension portion and that extends to the location corresponding to that of the respective one of the solder points on the chip-mounting region of the substrate.

Other features and advantages of the present invention will become apparent in the following detailed description of the preferred embodiments with reference to the accompanying drawings, of which:
Figure 1 is a sectional view illustrating a semiconductor chip to be mounted on a substrate according to the first preferred embodiment of a mounting method of the present invention;
Figure 2 is a schematic view illustrating a conductor-forming mold used in the mounting method of the first preferred embodiment;
Figure 3 is a sectional view of the conductor-forming mold, taken along lines III-III in Figure 2;
Figure 4 is a sectional view illustrating how conductive bodies are formed in conductor-receiving cavities of the conductor-forming mold according to the mounting method of the first preferred embodiment;
Figure 5 is a sectional view illustrating how the conductive bodies are transferred to the semiconductor chip of Figure 1 according to the mounting method of the first preferred embodiment;
Figure 6 is a sectional view illustrating how a semiconductor device prepared according to the mounting method of the first preferred embodiment is mounted on a substrate;
Figure 7 is a sectional view illustrating how a semiconductor device is prepared according to the second preferred embodiment of a mounting method of the present invention;
Figure 8 is a sectional view of the semiconductor device prepared according to the mounting method of the second preferred embodiment;
Figure 9 is a sectional view illustrating how the semiconductor device of Figure 8 is mounted on a substrate in accordance with the mounting method of the second preferred embodiment;
Figure 10 is a sectional view illustrating a semiconductor device prepared according to the third preferred embodiment of a mounting method of the present invention;
Figure 11 is a schematic view illustrating a conductor-forming plate used in the fourth preferred embodiment of a mounting method of the present invention;
Figure 12 is a schematic view illustrating the conductor-forming plate of Figure 11 when superimposed upon the semiconductor chip of Figure 1 in accordance with the mounting method of the fourth preferred embodiment;
Figure 13 is a sectional view taken along lines XIII-XIII in Figure 12;
Figure 14 is a schematic view illustrating the semiconductor chip of Figure 12 after undergoing a printing step according to the mounting method of the fourth preferred embodiment;
Figure 15 is a sectional view taken along lines XV-XV in Figure 14;
Figure 16 is a sectional view illustrating a semiconductor device prepared according to the mounting method of the fourth preferred embodiment;
Figure 17 is a schematic view illustrating a semiconductor chip after undergoing a printing step according to the fifth preferred embodiment of a mounting method of this invention;
Figure 18 is a schematic view illustrating a semiconductor chip after undergoing a printing step according to the sixth preferred embodiment of a mounting method of this invention,
Figure 19 is a sectional view illustrating a semiconductor chip to be mounted on a substrate according to the seventh preferred embodiment of a mounting method according to the present invention;
Figure 20 is a schematic view illustrating a patterned mask used in the mounting method of the seventh preferred embodiment;
Figure 21 is a schematic view illustrating the patterned mask of Figure 20 when superimposed upon the semiconductor chip of Figure 19 in accordance with the mounting method of the seventh preferred embodiment;
Figure 22 is a sectional view taken along lines XXII-XXII in Figure 21;
Figure 23 is a sectional view illustrating the semiconductor chip of Figure 22 after undergoing an etching step according to the mounting method of the seventh preferred embodiment;
Figure 24 is a sectional view illustrating a semiconductor device prepared according to the mounting method of the seventh preferred embodiment; and
Figure 25 is a fragmentary schematic view illustrating another semiconductor chip that can be used in the mounting method of the present invention.

Before the present invention is described in greater detail, it should be noted that like elements are denoted by the same reference numerals throughout the disclosure.

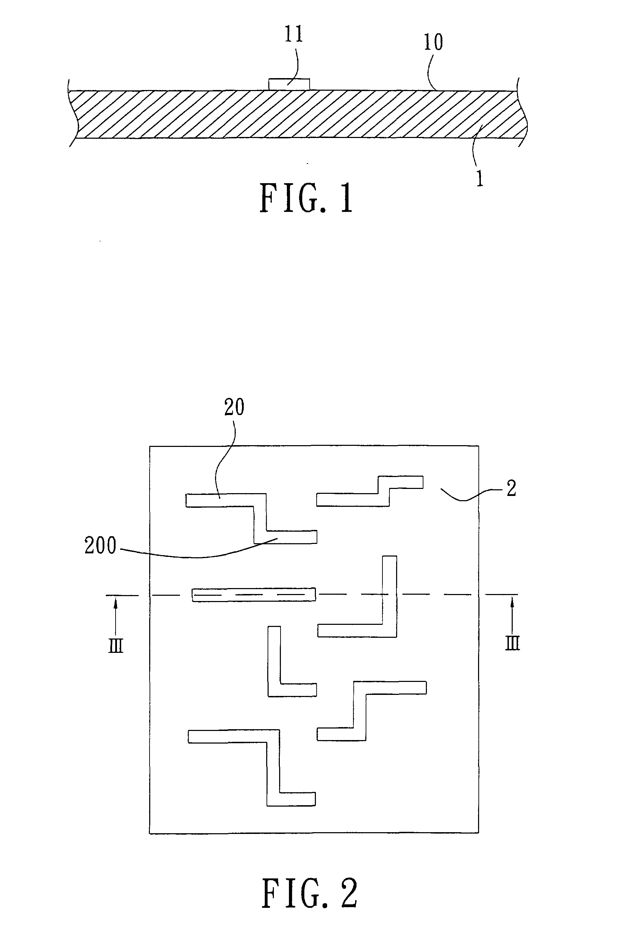

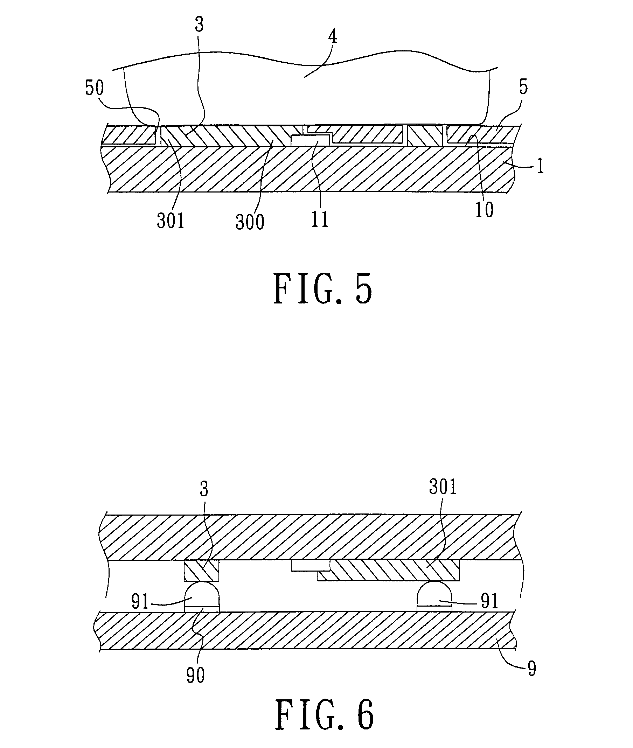

Referring to Figure 1, in the first preferred embodiment of a mounting method according to the present invention, there is provided a semiconductor chip 1 having a pad-mounting surface 10 with a plurality of bonding pads 11 (only one is shown in this Figure) provided thereon. The semiconductor chip 1 is to be mounted on a substrate 9 (see Figure 6). The substrate 9, such as a system board, has a chip-mounting region provided with a plurality of solder points 90. The bonding pads 11 are to be connected to corresponding ones of the solder points 90, but are disposed on the pad-mounting surface 10 at locations that are offset from locations of the corresponding ones of the solder points 90 on the chip-mounting region.

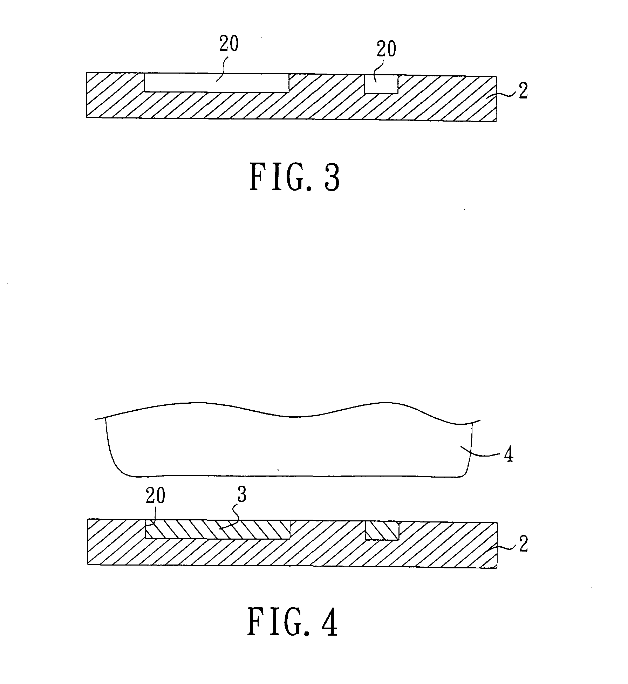

Referring to Figures 2 and 3, there is provided a conductor-forming mold 2 having one side formed with a plurality of non-intersecting conductor-receiving cavities 20. Each of the conductor-receiving cavities 20 has a first cavity part 200 that is disposed in the conductor-forming mold 2 at a location corresponding to that of a respective one of the bonding pads 11 on the pad-mounting surface 10, and a second cavity part 201 that extends from the first cavity part 200 and that is disposed in the conductor-forming mold 2 at a location corresponding to that of a respective one of the solder points 90 on the chip-mounting region of the substrate 9 (see Figure 6).

Thereafter, as shown in Figure 4, non-intersecting conductive bodies 3 are formed respectively in the conductor-receiving cavities 20 by filling the latter with a conductive metal paste, such as one that contains silver, gold, copper, iron, aluminum, tin, lead or other conductive metal materials.

Referring to Figure 5, a conductor-positioning plate 5 is superimposed on the pad-mounting surface 10 of the semiconductor chip 1. The conductor-positioning plate 5 is formed with a plurality of conductor-positioning holes 50 that correspond in size, shape and position with the conductor-receiving cavities 20 in the conductor-forming mold 2, respectively. Subsequently, with the use of a transfer printing unit 4, the conductive bodies 3 are transferred from the conductor-forming mold 2 via known transfer printing techniques (see Figure 4), and are fitted into the conductor-positioning holes 50 in the conductor-positioning plate 5 for mounting on the pad-mounting surface 10 of the semiconductor chip 1. The conductor-positioning plate 5 prevents lateral deformation of the conductive bodies 3 when the latter are pressed by the transfer printing unit 4 toward the pad-mounting surface 10 of the semiconductor chip 1. Upon removal of the conductor-positioning plate 5 from the pad-mounting surface 10, the conductive bodies 3 are processed by heating and drying to harden the same. A semiconductor device is thus obtained. Each of the conductive bodies 3 of the semiconductor device has an elongate extension portion 300 that is formed in the first cavity part 200 of the respective conductor-receiving cavity 20, and an electrical connection portion 301 that is formed in the second cavity part 201 of the respective conductor-receiving cavity 200 on one end of the extension portion 300. The extension portion 300 is connected electrically to a respective one of the bonding pads 11. The electrical connection portion 301 extends to the location corresponding to that of a respective one of the solder points 90 on the chip-mounting region of the substrate 9 (see Figure 6) for electrical connection therewith.

As shown in Figure 6, the semiconductor device thus obtained is mounted on the chip-mounting region of the substrate 9. The electrical connection portions 301 of the conductive bodies 3 are connected to the corresponding ones of the solder points 90 via conductive paste 91 pre-disposed on the latter, thereby establishing electrical connection between the semiconductor chip 1 and the substrate 9. Alternatively, connection between the electrical connection portions 301 of the conductive bodies 3 and the solder points 90 can be established via solder paste on the latter.

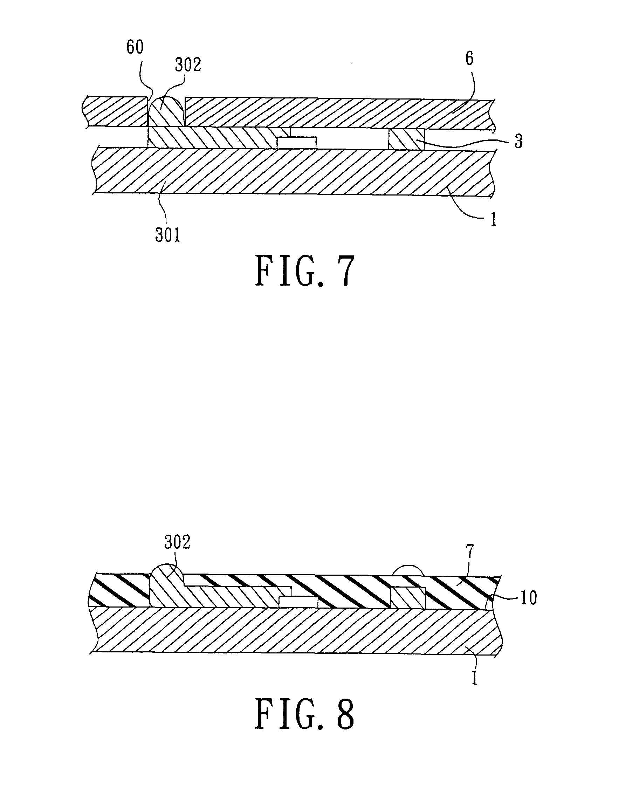

Referring to Figure 7, in the second preferred embodiment of a mounting method according to the present invention, after the conductive bodies 3 are mounted on the pad-mounting surface 10 of the semiconductor chip 1 in accordance with the mounting method of the first preferred embodiment, a protrusion-forming plate 6 that is formed with a plurality of protrusion-forming holes 60 (only one is shown in this Figure) is superimposed on the pad-mounting surface 10 of the semiconductor chip 1. Each of the protrusion-forming holes 60 is registered with the electrical connection portion 301 of a respective one of the conductive bodies 3 on the semiconductor chip 1, and is confined by a wall that cooperates with the electrical connection portion 301 of the respective one of the conductive bodies 3 to form a protrusion-receiving space. Thereafter, conductive protrusions 302 are formed respectively in the protrusion-receiving spaces via a printing technique that uses a conductive metal paste as printing material. Because the conductive protrusions 302 and the conductive bodies 3 are made from the same material, the conductive protrusions 302 can fuse with the electrical connection portions 301 of the conductive bodies 3. Upon removal of the protrusion-forming plate 6 from the pad-mounting surface 10 of the semiconductor chip 1, the conductive bodies 3 and the conductive protrusions 302 are processed by heating and drying to harden the same.

Thereafter, as shown in Figure 8, a protective layer 7 made of an insulator material, such as a resin, is formed on the pad-mounting surface 10 of the semiconductor chip 1. The conductive protrusions 302 protrude through the protective layer 7. A semiconductor device is thus obtained.

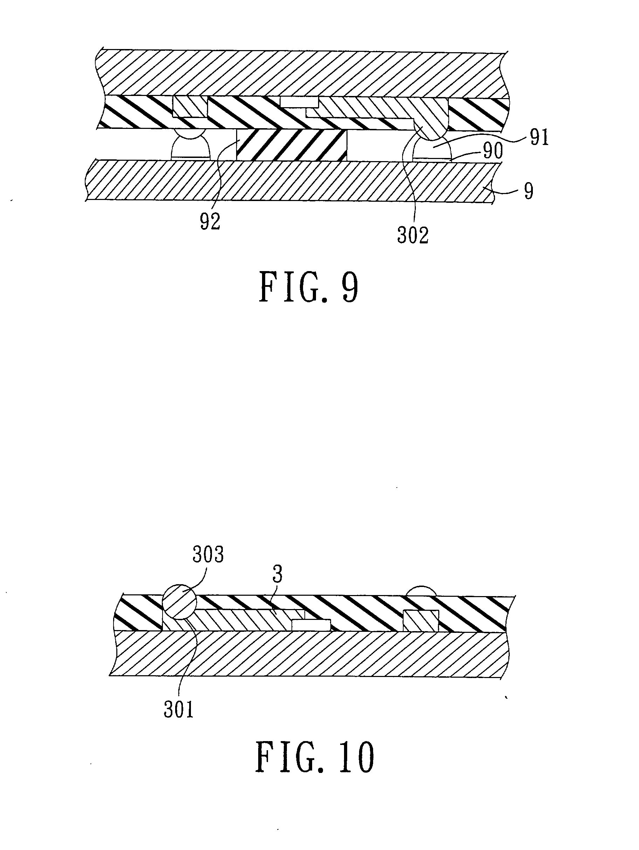

Referring to Figure 9, the semiconductor device of Figure 8 is mounted on the chip-mounting region of a substrate 9. The conductive protrusions 302 are connected to the corresponding ones of the solder points 90 via conductive paste 91 pre-disposed on the latter, thereby establishing electrical connection between the semiconductor chip 1 and the substrate 9. Preferably, an adhesive layer 92 adheres the semiconductor device of Figure 8 to the chip-mounting region of the substrate 9 to prevent relative movement therebetween prior to heating of the assembly of the semiconductor device and the substrate 9 so as to harden the conductive paste 91.

Like the first preferred embodiment, connection between the conductive protrusions 302 and the solder points 90 can be established via solder paste on the latter. The adhesive layer 92 can be eliminated due to the use of the solder paste.

Figure 10 illustrates a semiconductor device prepared according to the third preferred embodiment of a mounting method according to the present invention. Unlike the second preferred embodiment, after the conductive bodies 3 are mounted on the pad-mounting surface 10 of the semiconductor chip 1, a conductive ball 303 is provided on the electrical connection portion 301 of each of the conductive bodies 3. In this embodiment, the conductive ball 303 is a copper ball electroplated with a conductive metal material, such as gold, silver, tin or aluminum.

When the semiconductor device of Figure 10 is mounted on the chip-mounting region of a substrate, the conductive balls 303 are connected to the corresponding ones of the solder points on the chip-mounting region via conductive paste or solder paste pre-disposed on the latter, thereby establishing electrical connection between the semiconductor chip 1 and the substrate.

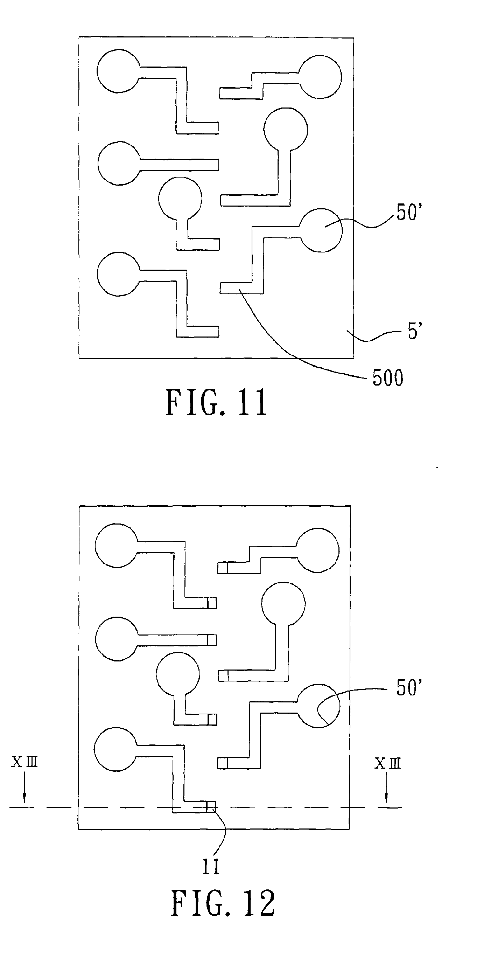

Referring to Figures 11 to 13, in the fourth preferred embodiment of a mounting method according to the present invention, there is provided a conductor-forming plate 5' that is superimposed on the pad-mounting surface 10 of the semiconductor chip 1. In this embodiment, the conductor-forming plate 5' is a printing screen plate, and is formed with a plurality of non-intersecting holes 50' at positions registered with the bonding pads 11 on the pad-mounting surface 10. Each of the holes 50' includes a first hole part 500 that exposes at least a part of the registered one of the bonding pads 11 on the pad-mounting surface 10, and a second hole part 501 that exposes a respective portion of the pad mounting surface 10 and that extends from the first hole part 500 to a location corresponding to that of a respective one of the solder points on the chip-mounting region of the substrate. Each of the holes 50' is confined by a wall that cooperates with the pad-mounting surface 10 to form a conductor-receiving space.

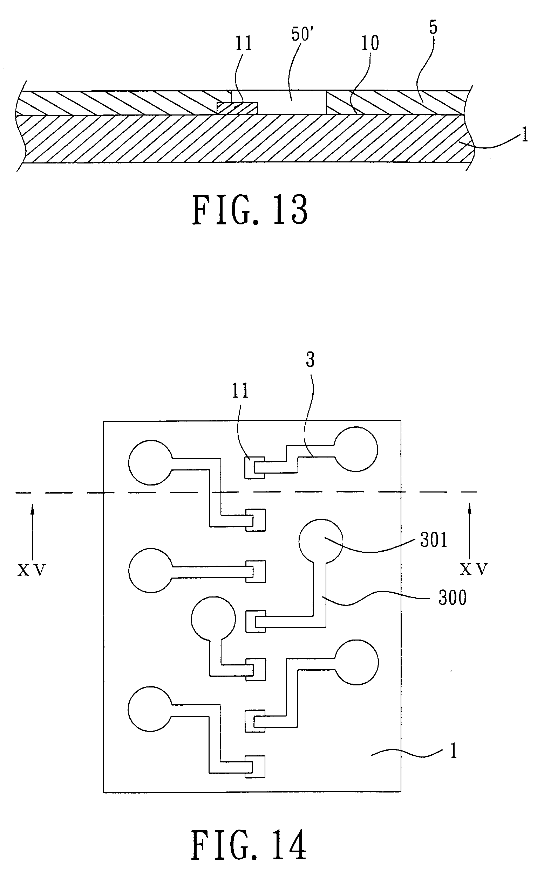

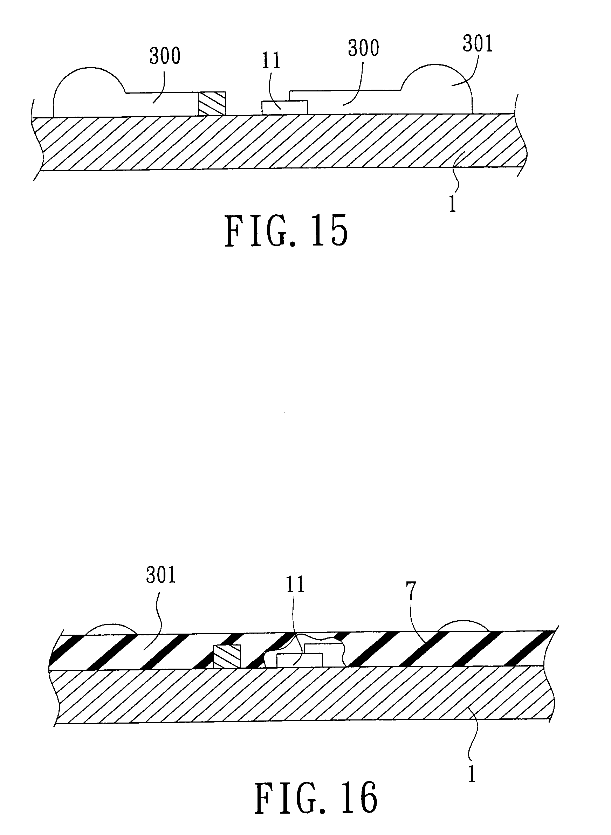

Thereafter, as shown in Figures 14 and 15, non-intersecting conductive bodies 3 are formed respectively in the conductor-receiving spaces via a printing technique that uses a conductive metal paste as printing material. Upon removal of the conductor-forming plate 5' from the pad-mounting surface 10, the conductive bodies 3 are processed by heating and drying to harden the same. Like the previous embodiments, each of the conductive bodies 3 has an elongate extension portion 300 that is formed in the first hole part 500 so as to connect electrically with the registered one of the bonding pads 11, and an electrical connection portion 301 that is formed in the second hole part 501 on one end of the extension portion 300 and that extends to the location corresponding to that of the respective one of the solder points on the chip mounting region of the substrate for electrical connection therewith.

Referring to Figure 16, a protective layer 7 made of an insulator material, such as resin, is formed on the pad-mounting surface 10 of the semiconductor chip 1. The electrical connection portion 301 of each of the conductive bodies 3 has a conductive protuberance that protrudes through the protective layer 7. A semiconductor device is thus obtained.

Like the previous embodiments, when the semiconductor device of Figure 16 is mounted on the chip-mounting region of a substrate, the conductive protuberances on the electrical connection portions 301 of the conductive bodies 3 are connected to the corresponding ones of the solder points on the chip-mounting region via conductive paste or solder paste pre-disposed on the latter, thereby establishing electrical connection between the semiconductor chip 1 and the substrate.

It should be understood that, by controlling the sizes of the holes 50' in the conductor-forming plate 5', the thickness of the electrical connection portions 301 of the conductive bodies 3 can be controlled accordingly. In addition, instead of the conductive protuberances, the electrical connection portions 301 of the conductive bodies 3 can be provided with the conductive protrusion 302 of the embodiment of Figure 8, or the conductive ball 303 of the embodiment of Figure 10 in the manner described beforehand.

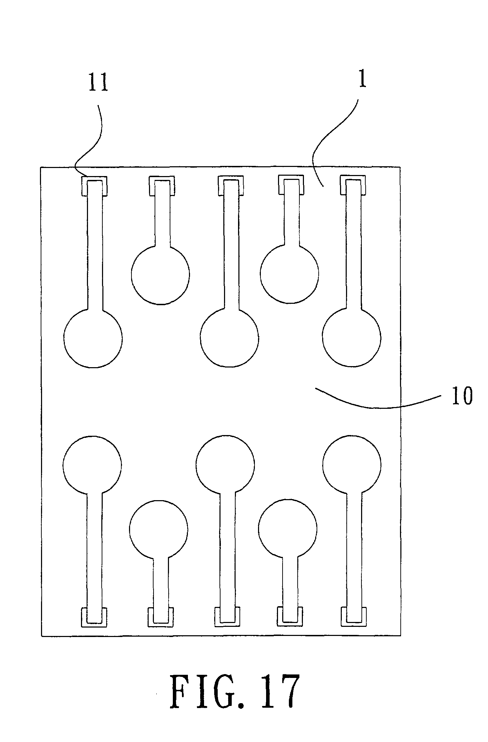

Referring to Figure 17, in the fifth preferred embodiment of a mounting method according to the present invention, the bonding pads 11 of the semiconductor chip 1 are disposed on opposite side portions of the pad-mounting surface 10.

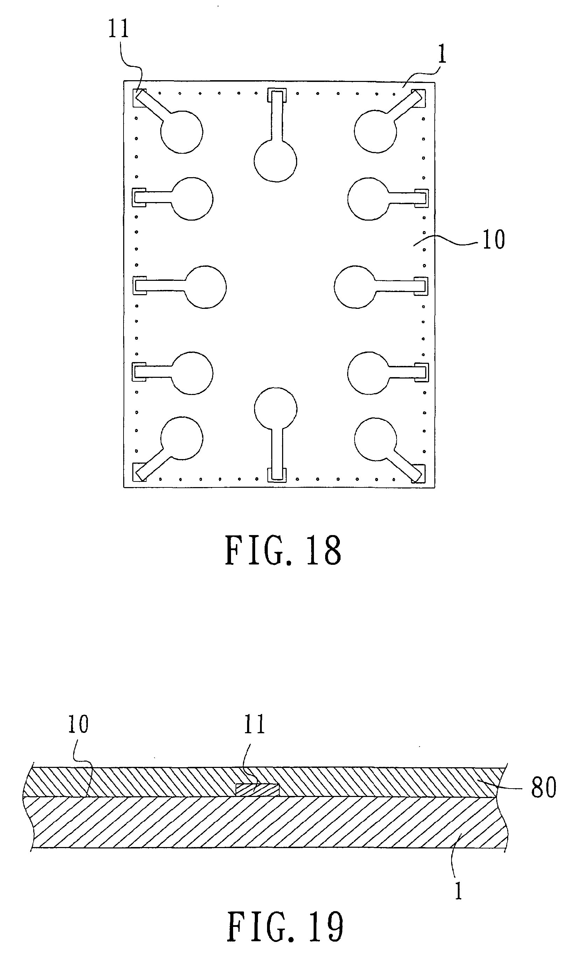

Referring to Figure 18, in the sixth preferred embodiment of a mounting method according to the present invention, the bonding pads 11 of the semiconductor chip 1 are disposed on four side portions of the pad-mounting surface 10.

Referring to Figure 19, in the seventh preferred embodiment of a mounting method according to the present invention, a positive photoresist film layer 80 is formed on the pad-mounting surface 10 of the semiconductor chip 1.

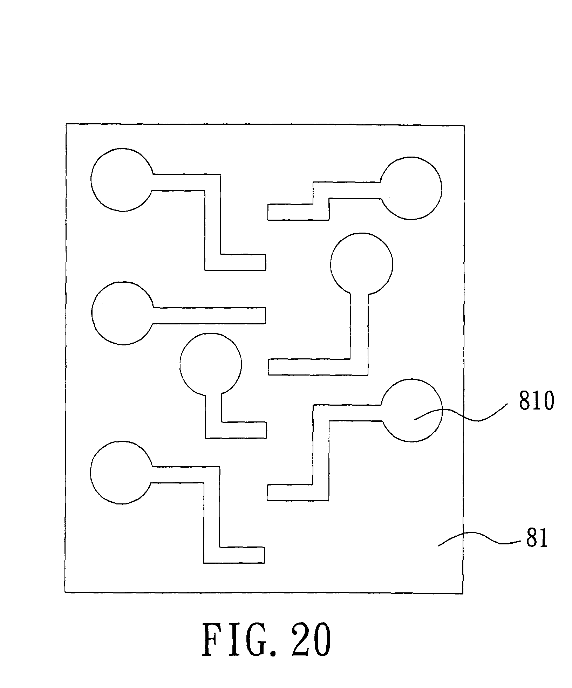

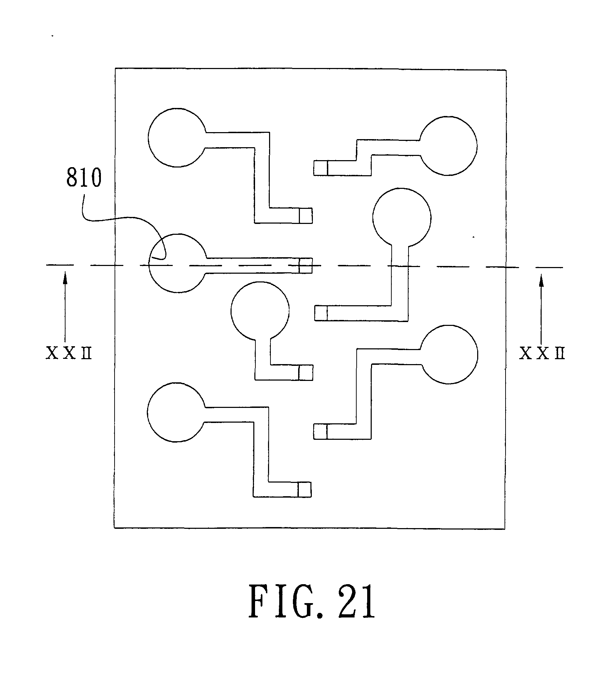

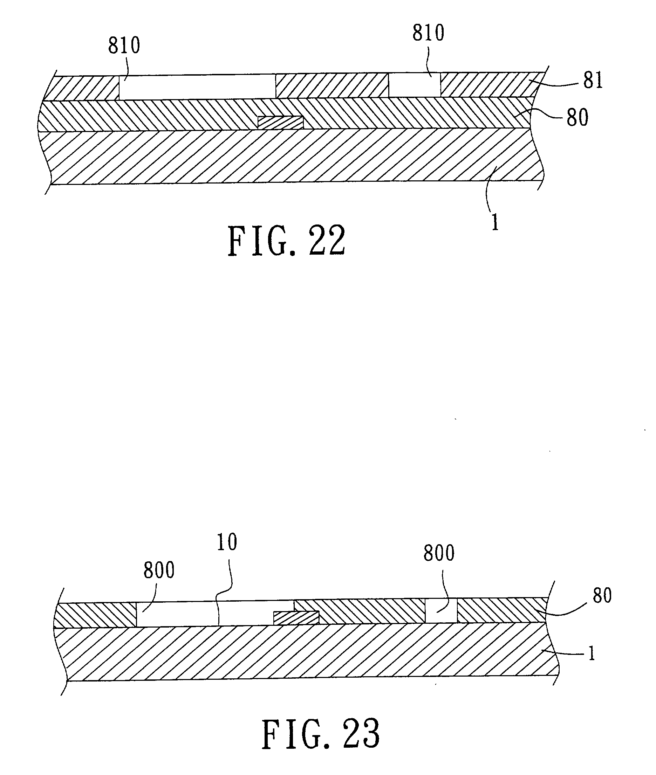

Referring to Figures 20 to 22, there is provided a patterned mask 81 that is superimposed on the photoresist film layer 80. The patterned mask 81 is formed with a plurality of light transmissive portions 810 at positions registered with the bonding pads 11 on the pad-mounting surface 10. Using known lithography techniques, including exposure to ultraviolet light and chemical developing, the exposed portions of the photoresist film layer 80 are removed to form non-intersecting conductor-receiving cavities 800 therein, as shown in Figure 23. The conductor-receiving cavities 800 are disposed at positions registered with the bonding pads 11 on the pad-mounting surface 10. Each of the conductor-receiving cavities 800 includes a first cavity part that exposes at least a part of the registered one of the bonding pads 11 on the pad-mounting surface 10, and a second cavity part that exposes a respective portion of the pad-mounting surface 10 and that extends from the first cavity part to a location corresponding to that of a respective one of the solder points on the chip-mounting region of the substrate.

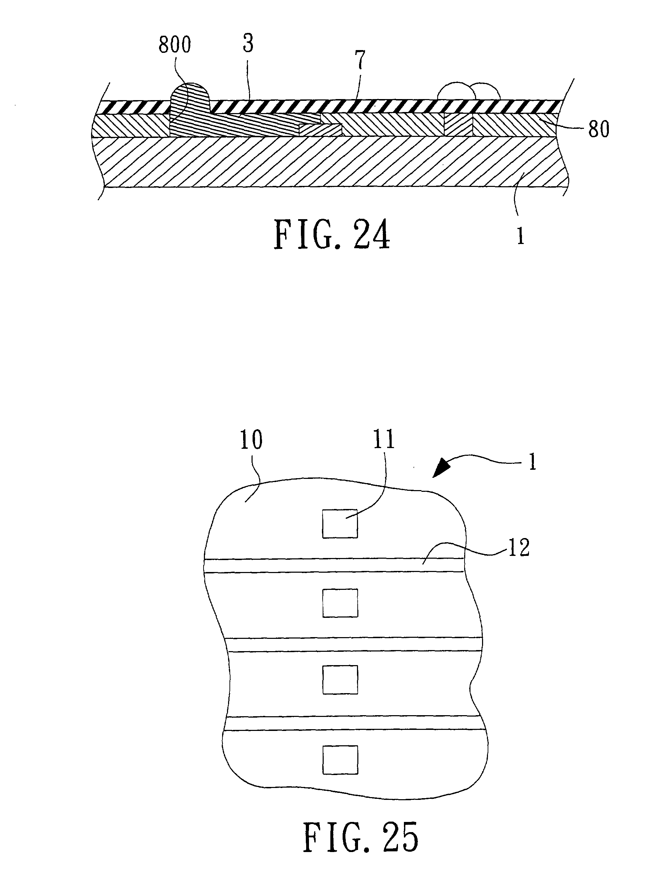

Thereafter, as shown in Figure 24, non-intersecting conductive bodies 3 are formed respectively in the conductor-receiving cavities 800, such as by printing with the use of a conductive metal paste as printing material Like the previous embodiments, each of the conductive bodies 3 has an extension portion that is disposed in the first cavity part so as to connect electrically with the registered one of the bonding pads 11, and an electrical connection portion 301 that is disposed in the second cavity part on one end of the extension portion 300 and that extends to the location corresponding to that of the respective one of the solder points on the chip-mounting region of the substrate. A protective layer 7 made of an insulator material, such as resin, is formed on the photoresist film layer 80 to cover the connections formed among the conductive bodies 3 and the bonding pads 11. Like the embodiment of Figure 16, the electrical connection portion 301 of each of the conductive bodies 3 has a conductive protuberance that protrudes through the protective layer 7. Alternatively, instead of the conductive protuberances, the electrical connection portions 301 of the conductive bodies 3 can be provided with the conductive protrusion 302 of the embodiment of Figure 8, or the conductive ball 303 of the embodiment of Figure 10 in the manner described beforehand. A semiconductor device is thus obtained.

As to how the semiconductor device of Figure 24 is mounted on the chip-mounting region of a substrate, this can be accomplished in a manner similar to that described in connection with the previous embodiments and will not be detailed further for the sake of brevity.

Referring to Figure 25, in order to prevent the occurrence of short-circuiting due to the relatively short distance between adjacent ones of the bonding pads 11, an insulator barrier 12, made of resin, may be formed on the pad-mounting surface 10 of the semiconductor chip 1 between every adjacent pair of the bonding pads 11.

## Claims

1. A method for mounting a semiconductor chip on a substrate, the substrate having a chip-mounting region provided with a plurality of solder points, the semiconductor chip having a pad-mounting surface provided with a plurality of bonding pads, which are to be connected to corresponding ones of the solder points and which are disposed on the pad-mounting surface at locations that are offset from locations of the corresponding ones of the solder points on the chip-mounting region, said method comprising the steps of:
providing a conductor-forming mold having one side formed with a plurality of conductor-receiving cavities, each of the conductor-receiving cavities having a first cavity part that is disposed in the conductor-forming mold at a location corresponding to that of a respective one of the bonding pads on the pad-mounting surface, and a second cavity part that extends from the first cavity part and that is disposed in the conductor-forming mold at a location corresponding to that of a respective one of the solder points on the chip-mounting region of the substrate;
filling the conductor-receiving cavities with a conductive metal paste to form conductive bodies respectively therein, each of the conductive bodies having an extension portion that is disposed in the first cavity part of the respective one of the conductor-receiving cavities, and an electrical connection portion that is disposed in the second cavity part of the respective one of the conductor-receiving cavities on one end of the extension portion; and
through a transfer printing unit, transferring the conductive bodies from the conductor-forming mold to the pad-mounting surface of the semiconductor chip such that the extension portion of each of the conductive bodies is connected electrically to the respective one of the bonding pads, and such that the electrical connection portion of each of the conductive bodies extends to the location corresponding to that of the respective one of the solder points on the chip-mounting region of the substrate.

2. The method of Claim 1, further comprising the step of mounting the semiconductor chip on the chip-mounting region of the substrate such that the electrical connection portions of the conductive bodies are connected to the corresponding ones of the solder points, thereby establishing electrical connection between the semiconductor chip and the substrate.

3. The method of Claim 1 or 2, further comprising, prior to the step of transferring the conductive bodies to the pad-mounting surface, the step of forming an insulator barrier between every adjacent pair of the bonding pads.

4. The method of any of the preceding claims, further comprising, prior to the step of transferring the conductive bodies to the pad-mounting surface, the step of superimposing a conductor-positioning plate on the pad-mounting surface of the semiconductor chip, the conductor-positioning plate being formed with a plurality of conductor-positioning holes that correspond in size, shape and position with the conductor-receiving cavities in the conductor-forming mold, the conductive bodies being fitted into the conductor-positioning holes in the conductor-positioning plate by the transfer printing unit when the conductive bodies are transferred from the conductor-forming mold to the pad-mounting surface of the semiconductor chip.

5. The method of any of the preceding claims, further comprising the step of providing a conductive ball on the electrical connection portion of each of the conductive bodies.

6. The method of Claim 5, further comprising the step of forming a protective layer made of an insulator material on the pad-mounting surface of the semiconductor chip, the conductive balls protruding through the protective layer.

7. The method of Claim 6, further comprising the step of mounting the semiconductor chip on the chip-mounting region of the substrate such that the conductive balls are connected to the corresponding ones of the solder points, thereby establishing electrical connection between the semiconductor chip and the substrate.

8. The method of any of the preceding claims, further comprising the steps of:
superimposing a protrusion-forming plate formed with a plurality of protrusion-forming holes on the pad-mounting surface of the semiconductor chip, each of the protrusion-forming holes being registered with the electrical connection portion of a respective one of the conductive bodies, and being confined by a wall that cooperates with the electrical connection portion of the respective one of the conductive bodies to form a protrusion-receiving space; and
using a conductive metal paste as printing material, printing on the protrusion-forming plate to form conductive protrusions in the protrusion-receiving spaces.

9. The method of Claim 8, further comprising the steps of removing the protrusion-forming plate from the pad-mounting surface of the semiconductor chip, and forming a protective layer made of an insulator material on the pad-mounting surface of the semiconductor chip, the conductive protrusions protruding through the protective layer.

10. The method of Claim 9, further comprising the step of mounting the semiconductor chip on the chip-mounting region of the substrate such that the conductive protrusions are connected to the corresponding ones of the solder points, thereby establishing electrical connection between the semiconductor chip and the substrate.

11. A method for mounting a semiconductor chip on a substrate, the substrate having a chip-mounting region provided with a plurality of solder points, the semiconductor chip having a pad-mounting surface provided with a plurality of bonding pads, which are to be connected to corresponding ones of the solder points and which are disposed on the pad-mounting surface at locations that are offset from locations of the corresponding ones of the solder points on the chip-mounting region, said method comprising the steps of:
superimposing a conductor-forming plate on the pad-mounting surface of the semiconductor chip, the conductor-forming plate being formed with a plurality of holes at positions registered with the bonding pads on the pad-mounting surface, each of the holes having a first hole part that exposes at least a part of the registered one of the bonding pads on the pad-mounting surface, and a second hole part that exposes a respective portion of the pad-mounting surface and that extends from the first hole part to a location corresponding to that of a respective one of the solder points on the chip-mounting region of the substrate, the holes being confined by walls that cooperate with the pad-mounting surface to form conductor-receiving spaces; and
using a conductive metal paste as printing material, printing on the conductor-forming plate to form conductive bodies in the conductor-receiving spaces, each of the conductive bodies having an extension portion that is disposed in the first hole part to connect electrically with the registered one of the bonding pads, and an electrical connection portion that is disposed in the second hole partion one end of the extension portion and that extends to the location corresponding to that of the respective one of the solder points on the chip-mounting region of the substrate.

12. The method of Claim 11, further comprising the steps of removing the conductor-forming plate from the pad-mounting surface, and mounting the semiconductor chip on the chip-mounting region of the substrate such that the electrical connection portions of the conductive bodies are connected to the corresponding ones of the solder points, thereby establishing electrical connection between the semiconductor chip and the substrate.

13. The method of Claim 12, further comprising, prior to the step of mounting the semiconductor chip on the chip-mounting region, the step of forming a protective layer made of an insulator material on the pad-mounting surface of the semiconductor chip.

14. The method of any one of claims 11 to 13, further comprising, prior to the step of superimposing the conductor-forming plate on the pad-mounting surface, the step of forming an insulator barrier between every adjacent pair of the bonding pads.

15. A method for mounting a semiconductor chip on a substrate, the substrate having a chip-mounting region provided with a plurality of solder points, the semiconductor chip having a pad-mounting surface provided with a plurality of bonding pads, which are to be connected to corresponding ones of the solder points and which are disposed on the pad-mounting surface at locations that are offset from locations of the corresponding ones of the solder points on the chip-mounting region, said method comprising the steps of:
forming a photoresist layer on the pad-mounting surface of the semiconductor chip;
forming a plurality of conductor-receiving cavities in the photoresist layer at positions registered with the bonding pads on the pad-mounting surface, each of the conductor-receiving cavities having a first cavity part that exposes at least a part of the registered one of the bonding pads on the pad-mounting surface, and a second cavity part that exposes a respective portion of the pad-mounting surface and that extends from the first cavity part to a location corresponding to that of a respective one of the solder points on the chip-mounting region of the substrate; and
forming conductive bodies in the conductor-receiving cavities, each of the conductive bodies having an extension portion that is disposed in the first cavity part to connect electrically with the registered one of the bonding pads, and an electrical connection portion that is disposed in the second cavity part on one end of the extension portion and that extends to the location corresponding to that of the respective one of the solder points on the chip-mounting region of the substrate.

16. The method of Claim 15, further comprising the step of mounting the semiconductor chip on the chip-mounting region of the substrate such that the electrical connection portions of the conductive bodies are connected to the corresponding ones of the solder points, thereby establishing electrical connection between the semiconductor chip and the substrate.

17. The method of Claim 16, further comprising, prior to the step of mounting the semiconductor chip on the chip-mounting region, the step of forming a protective layer made of an insulator material on the photoresist layer.

18. The method of any one of claims 15 to 17, further comprising, prior to the step of forming the photoresist layer, the step of forming an insulator barrier between every adjacent pair of the bonding pads.

19. A semiconductor device adapted for mounting on a substrate, the substrate having a chip-mounting region provided with a plurality of solder points, said semiconductor device comprising:
a semiconductor chip having a pad-mounting surface provided with a plurality of bonding pads which are disposed on said pad-mounting surface at locations that are offset from locations of corresponding ones of the solder points on the chip-mounting region; and
a plurality of conductive bodies, each of which has an extension portion that is connected electrically to a respective one of said bonding pads, and an electrical connection portion that is formed on one end of said extension portion and that extends to a location corresponding to that of a respective one of the solder points on the chip-mounting region of the substrate, said conductive bodies being formed by:
providing a conductor-forming mold having one side formed with a plurality of conductor-receiving cavities, each of said conductor-receiving cavities having a first cavity part that is disposed in said conductor-forming mold at a location corresponding to that of a respective one of said bonding pads on said pad-mounting surface, and a second cavity part that extends from said first cavity part and that is disposed in said conductor-forming mold at a location corresponding to that of a respective one of the solder points on the chip-mounting region of the substrate;
filling said conductor-receiving cavities with a conductive metal paste to form said conductive bodies respectively therein, said extension portions of said conductive bodies being disposed in said first cavity parts of said conductor-receiving cavities, said electrical connection portions of said conductive bodies being disposed in said second cavity parts of said conductor-receiving cavities; and
through a transfer printing unit, transferring said conductive bodies from said conductor-forming mold to said pad-mounting surface of said semiconductor chip.

20. The semiconductor device of Claim 19, further comprising a plurality of insulator barriers, each of which is formed on said pad-mounting surface between an adjacent pair of said bonding pads.

21. The semiconductor device of Claim 20, wherein said insulator barriers are formed from a resin material.

22. The semiconductor device of Claim 19, further comprising a plurality of conductive balls, each of which is disposed on said electrical connection portion of a respective one of said conductive bodies.

23. The semiconductor device of Claim 22, further comprising a protective layer made of an insulator material and formed on said pad-mounting surface of said semiconductor chip, said conductive balls protruding through said protective layer.

24. The semiconductor device of any one of claims 19 to 23, wherein said electrical connection portion of each of said conductive bodies has a conductive protrusion formed thereon.

25. The semiconductor device of Claim 24, further comprising a protective layer made of an insulator material and formed on said pad-mounting surface of said semiconductor chip, said conductive protrusions protruding through said protective layer.

26. A semiconductor device adapted for mounting on a substrate, the substrate having a chip-mounting region provided with a plurality of solder points, said semiconductor device comprising:
a semiconductor chip having a pad-mounting surface provided with a plurality of bonding pads which are disposed on said pad-mounting surface at locations that are offset from locations of corresponding ones of the solder points on the chip-mounting region; and
a plurality of conductive bodies, each of which has an extension portion that is connected electrically to a respective one of said bonding pads, and an electrical connection portion that is formed on one end of said extension portion and that extends to a location corresponding to that of a respective one of the solder points on the chip-mounting region of the substrate, said conductive bodies being formed by:
superimposing a conductor-forming plate on said pad-mounting surface of said semiconductor chip, said conductor-forming plate being formed with a plurality of holes at positions registered with said bonding pads on said pad-mounting surface, each of said holes having a first hole part that exposes at least a part of the registered one of said bonding pads on said pad-mounting surface, and a second hole part that exposes a respective portion of said pad-mounting surface and that extends from said first hole part to a location corresponding to that of a respective one of the solder points on the chip-mounting region of the substrate, said holes being confined by walls that cooperate with said pad-mounting surface to form conductor-receiving spaces; and
using a conductive metal paste as printing material, printing on said conductor-forming plate to form said conductive bodies in said conductor-receiving spaces, said extension portions of said conductive bodies being disposed in said first hole parts of said holes, said electrical connection portions of said conductive bodies being disposed in said second hole parts of said holes.

27. The semiconductor device of Claim 26, further comprising a plurality of insulator barriers, each of which is formed on said pad-mounting surface between an adjacent pair of said bonding pads.

28. The semiconductor device of Claim 27, wherein said insulator barriers are formed from a resin material.

29. The semiconductor device of Claim 26, further comprising a protective layer made of an insulator material and formed on said pad-mounting surface of said semiconductor chip.

30. A semiconductor device adapted for mounting on a substrate, the substrate having a chip-mounting region provided with a plurality of solder points, said semiconductor device comprising:
a semiconductor chip having a pad-mounting surface provided with a plurality of bonding pads which are disposed on said pad-mounting surface at locations that are offset from locations of corresponding ones of the solder points on the chip-mounting region;
a photoresist layer formed on said pad-mounting surface of said semiconductor chip, said photoresist layer being formed with a plurality of conductor-receiving cavities at positions registered with said bonding pads on said pad-mounting surface, each of said conductor-receiving cavities having a first cavity part that exposes at least a part of the registered one of said bonding pads on said pad-mounting surface, and a second cavity part that exposes a respective portion of said pad-mounting surface and that extends from said first cavity part to a location corresponding to that of a respective one of the solder points on the chip-mounting region of the substrate; and
a plurality of conductive bodies formed respectively in said conductor-receiving cavities, each of said conductive bodies having an extension portion that is disposed in said first cavity part to connect electrically with the registered one of said bonding pads, and an electrical connection portion that is disposed in said second cavity part on one end of said extension portion and that extends to the location corresponding to that of the respective one of the solder points on the chip-mounting region of the substrate.

31. The semiconductor device of Claim 30, further comprising a plurality of insulator barriers, each of which is formed on said pad-mounting surface between an adjacent pair of said bonding pads.

32. The semiconductor device of Claim 31, wherein said insulator barriers are formed from a resin material.

33. The semiconductor device of any one of claims 30 to 32, further comprising a protective layer made of an insulator material and formed on said pad-mounting surface of said semiconductor chip.

34. The method for mounting a semiconductor chip on a substrate substantially as hereinbefore described with reference to and as illustrated in the accompanying drawings.

35. The semiconductor device adapted for mounting on a substrate substantially as hereinbefore described with reference to and as illustrated in the accompanying drawings.
